# EUROPEAN PATENT SPECIFICATION

(11) **EP 4 278 380 B1**
(45) Date of publication and mention of the grant of the patent: **22.07.2026**
(21) Application number: 22722161.1
(22) Date of filing: 08.04.2022
(51) Int. Cl.: H10W 70/05, H10W 40/10, H10W 40/25, H10W 70/65, H10W 72/00, H10W 72/50, H10W 72/60, H10W 72/90, H10W 76/157, H10W 90/00

(54) **ARRANGEMENT FOR A POWER MODULE, POWER MODULE AND METHOD FOR PRODUCING AN ARRANGEMENT FOR A POWER MODULE**
ANORDNUNG FÜR EIN LEISTUNGSMODUL, LEISTUNGSMODUL UND VERFAHREN ZUR HERSTELLUNG EINER ANORDNUNG FÜR EIN LEISTUNGSMODUL
AGENCEMENT POUR MODULE DE PUISSANCE, MODULE DE PUISSANCE ET PROCÉDÉ DE FABRICATION D'UN AGENCEMENT POUR MODULE DE PUISSANCE

(43) Date of publication of application: 22.11.2023
(73) Proprietor: Hitachi Energy Ltd, 8050 Zürich (CH)
(72) Inventor: TRUESSEL, Dominik, 5620 Bremgarten (CH); GUILLON, David, 8857 Vorderthal (CH)
(74) Representative: Epping - Hermann - Fischer
(86) International application number: PCT/EP2022/059452
(87) International publication number: WO 2023/193928

(56) References cited:
- DE-B3- 102019 128 634
- DE-T5- 112020 002 920
- JP-A- 2011 204 968
- US-A1- 2010 295 187

## Description

The present disclosure relates to an arrangement for a power module, a power module and a method for producing an arrangement for a power module.

It is an object to provide an improved arrangement for a power module, e.g. an arrangement with reliable and space saving electrical connections and/or electrical connections for high currents. Further objects are to provide a power module with such an arrangement and a method for producing such an arrangement.

Arrangements for a power module with multiple connection elements connecting to the same electrically conductive contact area are known from DE 11 2020 002920 T5 and DE 10 2019 128634 B3.

Embodiments of the disclosure relate to an improved arrangement for a power module, an improved power module and an improved method for producing an arrangement for a power module.

Firstly, the arrangement for a power module is specified. According to an embodiment, the arrangement for a power module comprises an electrically conductive contact area as well as a first and a second connection element for electrically connecting the contact area. The first connection element is firmly bonded to the contact area in a first bond region and the second connection element is welded to the first connection element in a second bond region by means of laser welding and not ultrasonic welding.

Usually, space in a power module for electrical connections is limited. Moreover, small power modules, i.e. with a small footprint, can be cheaper and can show improved electromagnetic behavior. This is particularly due to a smaller substrate size and lower parasitic inductance. Usually, a considerable amount of space is, however, needed for the preparation of the wire bond or ribbon bond connections on the top side contact of, e.g. a power semiconductor device of the power module or the top metallization of a substrate of the power module. In most cases, multiple parallel wire bond or ribbon bond connections are needed to achieve a considerable current capability. Also, a large amount of space is needed if multiple electrically parallel terminals are connected with the same metallization area of the substrate to achieve a sufficient current capability. A limited space also limits the number of connections and consequently the current capability.

The present invention is, inter alia, based on the recognition that a reduction of space consumption can be achieved by an arrangement of at least two connection elements of which a first connection element is firmly bonded to a contact area, like the top metallization of a substrate or the contact area of a power semiconductor device, and a second connection element is, instead of being bonded to the same contact area adjacent to the first connection element, being bonded onto the first connection element. In this way, the space consumption needed for the connection can be reduced by up to 50 %. Moreover, in this way, the current capability of the connection can be increased, especially, if the available space is limited, because both the first and the second connection element can be used to transport current.

Nevertheless, the quality of the electric connection provided by two connection elements with the first connection element bonded to a contact area and the second connection element bonded to the first connection element turned out to be dependent on the used bonding methods. For example, if both connection elements were welded by ultrasonic welding, strong thermal and mechanical stress is caused by vibrations. This could lead to damage to the joint between the contact area and the first connection element when the second connection element is welded to the first connection element. Moreover, metal particles are usually generated during ultrasonic welding and the amount of space for the placement of the bond tool, like the sonotrode, is large.

In order to get around these issues, in accordance with the invention, laser welding is used for welding the second connection element to, particularly onto, the first connection element. Laser welding does not produce vibrations as ultrasonic welding so that the joint between the contact area and the first connection element is not damaged because of missing mechanical impact.

The electrically conductive contact area may comprise or may be made of metal, like Al or Cu or Ni or Au or Ag or an alloy thereof. The contact area is a surface, onto which the first connection element is bonded. For example, the contact area is part of a substrate or a power semiconductor device or a terminal for an external electrical connection.

The first and the second connection element are electrically conductive. Both may comprise or consist of metal, like Cu or Al, Au, Ag or an alloy thereof. Each connection element may be configured to carry a current of at least 1 A or at least 10 A or at least 100 A.

The first connection element is firmly bonded to the contact area. "Firmly bonded" and "material bonded" are synonyms. For example, an end portion or terminal portion, respectively, of the first connection element is firmly bonded to the contact area. Likewise, an end portion or terminal portion, respectively, of the second connection element may be laser welded to the first connection element.

Herein and in the following, if an element is bonded to another element, this particularly means that these elements are directly bonded to each other. Two elements bonded to each other are also electrically connected to each other.

The first connection element is firmly bonded to the contact area by means of one or more joints, in the following also referred to as first joint(s). The first bond region is defined as the region in which the one or more first joints between the first connection element and the contact area are formed. No joints between the first connection element and the contact area are formed outside of the first bond region. For example, only one contiguous first joint is formed between the contact area and the first connection element. Alternatively, a plurality of first joints may be formed between the first connection element and the contact area.

Likewise, due to the laser welding, the second connection element is firmly bonded to the first connection element by means of one or more joints, in the following also referred to as second joint(s). A second joint is, in particular, formed by a laser welded spot or a plurality of overlapping laser welded spots, wherein the spot diameter is defined by the laser beam diameter. The second bond region is defined as the region in which the one or more second joints between the second connection element and the first connection element are formed. For example, due to the laser welding, a plurality of second joints are formed between the second and the first connection element, wherein the second joints are spaced from each other pairwise.

A joint is herein understood to be an area over which a firm bond or material bond, respectively, between two elements is realized. In case of welding, a joint is, for example, the area where material is molten. Between two joints, there may be a contact between the two elements but there is no firm bond / material bond.

The first and/or the second bond region may each have extensions parallel to the contact area of, for example, at least 1 mm or at least 3 mm and/or of at most 10 mm or at most 5 mm. In case of only one joint defining the bond region, the area of the joint is equal to the area of the bond region. In case of a bond region defined by several, spaced joints, the area of each joint is smaller than the area of the assigned bond region. For example, the area of each joint is at most 25 % or at most 10 % of the area of the bond region. As an example, the extensions of each joint are then at most 2 mm or at most 1 mm or at most 0.5 mm.

Additionally to the first and second connection element, the arrangement may comprise one or more further connection elements. In this case, a third connection element is welded to the second connection element in a corresponding bond region by means of laser welding. An optional fourth connection element is welded to the third connection element in a corresponding bond region by means of laser welding and so on. Particularly, each two connection elements of the plurality of connection elements are welded onto each other by means of laser welding. All features disclosed herein in connection with the first and second connection element are correspondingly disclosed for the further connection elements. For example, bond regions between each two connections elements may overlap with the contact area and/or with each other in plan view of the contact area.

According to a further embodiment, the second connection element is provided with one or more coatings. For example, the second connection element comprises an anti-reflection coating at a top side that faces away from the first connection element. The top side is, for example, configured to face the impinging laser beam during laser welding. An efficiency of the irradiation with the laser beam can be improved by an anti-reflecting coating at the top side. Alternatively or additionally, the second connection element may comprise a coating, for example made from a noble metal, such as silver or gold, or nickel, at a bottom side facing the first connection element. Such a coating may prevent oxidation and can improve the laser welding process. The complete connection element may have such a coating.

Additionally or alternatively, the second connection element may comprise one or more coatings. All features disclosed in connection with the coating(s) for the second connection element are also disclosed for the coating(s) of the first connection element.

In accordance with the invention, the first and the second bond region at least partly, i.e. partly or completely, overlap with each other in plan view of the contact area. The second connection element may be welded onto the bond foot of the first connection element. The one or more second joints between the second connection element and the first connection element may at least partly overlap with the one or more first joints between the first connection element and the contact area when seen in plan view of the contact area. Alternatively, the second joints between the first and the second connection element may be in a staggered configuration with the first joints between the contact area and the first connection element so that no first joint overlaps with a second joint in that plan view. In plan view of the contact area, the first and the second bond region, in accordance with the invention, or the respective joints overlap with the contact area.

According to the claimed invention, the first connection element is welded to the contact area by means of ultrasonic welding. Alternatively, in exemplary embodiments falling outside the scope of the claimed invention, the first connection element is welded to the contact area by means of laser welding. It is also possible that the first connection element is soldered or sintered or firmly bonded to the contact area by any other suitable method, like gluing.

The skilled person is able to see which bonding method was used for bonding two elements. For example, ultrasonic welding produces shear displacements in the elements and the joints and/or imprints of the sonotrode. Laser welding produces, for example, small and well defined joints (welding spots) or multiple overlapping dots forming a continuous welding beam (scribeline or area), for example.

In the case of ultrasonic welding, there is, e.g., one single contiguous joint. In the case of laser welding there is, for example, a plurality of pairwise spaced joints.

According to a further embodiment, the second connection element comprises a welding structure prepared for improved laser welding. Such a welding structure can be realized by one or more thinned areas, slots, grooves and/or recesses in the second connection element. The welding structure may overlap with the second bond region or the second joints(s) between the first and second connection element, respectively, in plan view of the contact area. Alternatively or additionally, the complete portion of the second connection element overlapping with the second bond region may be formed thinner than a main body of the second connection element. For example, a range for the thickness of the thinned portion could be between 0.3 and 0.8 times the thickness of the main body.

Such specific structures can beneficially affect the laser welding process and can contribute to a reduction of needed heating power or energy impact of the laser irradiation by the laser beam on the second connection element and/or the structures below the second connection element. The welding process is done on such thinner portions so that the laser energy needed to realize a laser welded joint can be reduced due to a lower amount of metal to be molten and reduced lateral heat dissipation .

The implementation of holes or slots into the second connection element can enable a direct irradiation of the interface between the first connection element and the second connection element on the edges of the holes or slots so that a lower amount of metal has to be molten to realize a laser welded joint. Additionally, a lateral heat spreading may be prevented or reduced by holes, slots or grooves. For reduced lateral heat dissipation, holes, slots, or recesses may be also located outside of bond region.

According to a further embodiment, the first and the second connection element are stacked above each other. For example, the first connection element and the second connection element extend substantially parallel to each other.

According to a further embodiment, the first and the second connection element electrically connect the contact area to a further contact area of the arrangement. For example, the contact area and the further contact area are solely electrically connected via the connection elements.

The further contact area may, like the contact area, comprise or consist of metal, like Al or Cu or Ni or Au or Ag or an alloy thereof.

According to a further embodiment, the first connection element is firmly bonded to the further contact area in a third bond region. For example, the first connection element is firmly bonded to the further contact area by means of ultrasonic welding or laser welding or soldering or sintering. The portion of the first connection element firmly bonded to the further contact area may be an end portion or a terminal portion of the first connection element, respectively.

According to a further embodiment, the second connection element is welded onto the first connection element in a fourth bond region by means of laser welding. The portion of the second connection element welded to the first connection element in the fourth bond region may be an end portion or terminal portion of the second connection element, respectively.

The definition of the first and second bond region and all features disclosed in connection therewith correspondingly apply to the third and fourth bond region. Hence, the third and fourth bond regions may also be defined by the region in which corresponding joints are formed.

According to a further embodiment, the third and the fourth bond region or the corresponding joints, respectively, overlap at least partly with each other in plan view of the further contact area. Particularly, the third and the fourth bond region overlap at least partly with the further contact area in plan view of the further contact area.

Furthermore, the first connection element may be firmly bonded to a third and/or fourth and/or fifth and so on contact area. The second connection element may be laser welded to the first connection element in all these contact areas so that, for example, the corresponding bond regions overlap with each other and/or with the assigned contact area in plan view of that contact area. The connections to the third and/or fourth and/or fifth and so on contact area may be stitched connections.

According to a further embodiment, the contact area is formed by a top metallization of a substrate of the arrangement. The substrate may be an insulated metal substrate (IMS) with an electrically insulating resin layer sandwiched between the top metallization and a bottom metallization. Alternatively, the substrate may be an active metal bracing or a direct bonded copper (DBC) or direct bonded aluminum (DBA) substrate with a ceramic isolating sheet.

According to a further embodiment, the contact area is formed by a power semiconductor device, also referred to as power semiconductor chip, of the arrangement. The power semiconductor device may be a transistor, like a MOSFET, MISFET, IGBT, JFET or HEMTS, or a thyristor, or a diode. For example, the contact area is formed by a top side contact. The contact area may be electrically connected to or formed by a main electrode or a gate electrode of the power semiconductor device.

According to a further embodiment, the contact area is formed by a terminal of the arrangement. Herein, a terminal is understood as an element, e.g. of metal, typically Cu or Cu alloy, which is configured for an external electrical connection of the arrangement, i.e. for an electrical connection of the arrangement to an external component. The terminal is, e.g., a leadframe or busbar of the arrangement. The connection to the external component is, e.g., reversible.

Herein, a terminal is, for example, a sheet-like, rigid element. Each terminal may comprise a main body and at least one terminal foot. Between the main body and the terminal foot, the terminal may comprise a kink of, for example, 90°.

The terminal feet may each have a width of at least 1 mm and/or at most 15 mm. A thickness of the terminal feet is, in each case, at least 0.5 mm and/or at most 1.5 mm, for example.

According to a further embodiment, the further contact area is formed by a top metallization of a substrate of the arrangement or by a power semiconductor device of the arrangement or by a terminal of the arrangement.

According to a further embodiment, the first and/or the second connection element are ribbons. The ribbons may each have a width of at least 1 mm and/or at most 15 mm. A thickness of the ribbons may each be at least 1 µm or at least 20 µm and/or at most 2 mm. The ribbons may be flexible or bendable, respectively. The ribbons may be laser welded to each other at their bond feet.

According to a further embodiment, the first and/or the second connection element are terminals. The terminals are configured for an external electrical connection. The terminals may be laser welded to each other at their terminal feet.

According to a further embodiment, connection areas or connection portions, respectively, of the terminals are spaced apart from each other. The connection areas or portions are the areas or portions of the terminals provided for the external electrical connection. The connection areas/portions may be areas/portions of the terminals which are exposed, for example from the module housing or body in an unconnected state of the power module. The connection areas/portions may be used for interconnection of the power module. The connection areas/portions of the terminals may be spaced in lateral and/or vertical direction. A lateral direction is herein understood to be a direction parallel to a main extension plane of the arrangement or the power module, respectively. A vertical direction is a direction perpendicular to that main extension plane. For example, the contact area and/or the further contact area extend parallel to the main extension plane of the arrangement or the power module, respectively.

According to a further embodiment, the first and/or the second connection element are both clips. Clips are herein understood to be rigid, sheet-like structures. Clips are pre-bend structures. For example, each clip comprises at least two clip feet or end portions connected by a main body of the clip. Between the main body and each clip foot, there may be a kink. The clip feet may be configured to be welded to other elements. For example, the clip feet of the clips are laser welded to each other.

It is possible that the first and the second connection element are of the same type, for example both are ribbons or clips or terminals. Alternatively, the first and the second connection element may be of different types, for example one is a ribbon and the other one a clip or a terminal. Any other combination is also possible.

According to a further embodiment, one of the first and the second connection element is a main terminal. The main terminal is arranged for current or voltage supply or output to or from the power module. For example, a main terminal is configured to transport at least 1 A or at least 10 A or at least 100 A or at least 600 A.

According to a further embodiment, the other one of the first and the second connection element is an auxiliary terminal. An auxiliary terminal is, e.g., configured for controlling the power semiconductor devices, e.g. as gate terminal, or for current or voltage measurements. For example, a cross-sectional area of an auxiliary terminal perpendicular to which the current is running is at most 50 % or at most 10 % of the cross-sectional area of a main terminal.

According to a further embodiment, the second connection element is connected to the first connection element via a plurality of laser welded welding joints (these are the second joints introduced above). These welding joints are distributed over the second bond region and spaced pairwise from each other. For example, in the region between two adjacent welding joints, the first connection element and the second connection element are not firmly bonded to each other. In plan view of the contact area, the welding joints may each have a circular or an elongated shape. A distance between each two welding joints may be, e.g., at least 1 µm or at least 50 µm and/or at most 100 µm.

The features disclosed for the second joints in the last paragraph are also disclosed correspondingly for the first joints, in particular when the first connection element is welded to the contact area by means of laser welding.

Next, the power module is specified.

According to an embodiment of the power module, the power module comprises an arrangement according to any of the embodiments described herein.

Since the power module comprises an arrangement as described herein, all features disclosed for the arrangement are also disclosed for the power module and vice versa.

According to a further embodiment of the power module, the power module comprises a housing of an electrically insulating material. The arrangement may be at least partially embedded in the housing. The power module may further comprise one or more power semiconductor devices and one or more substrates, where the power semiconductor devices are mounted as specified above. Further, the power module may comprise a base plate on which the substrate(s) is/are mounted and which is configured for use as heat sink. The power module may also comprise main and auxiliary terminals.

The housing may be formed of a thermoplastic or a thermosetting resin material, which may be filled with inorganic particles or fibers. For example, the housing is at least partially formed by a resin body or by a resin frame filled with a gel or an epoxy. For example, a power semiconductor device of the power module is embedded in and encapsulated by the housing. The housing may be at least partially formed by a molding process, like transfer molding or injection molding.

The power module may be a device incorporating and electrically and mechanically interconnecting a plurality of power semiconductor devices. The power module may be adapted for processing currents of more than 10 A. The power module may be a low voltage module adapted for processing voltages below 1 kV or may be a medium voltage module adapted for processing voltages between 1 kV and 10 kV.

The power module may be employed in an electrical converter, which, for example, may rectify an AC voltage/current into a DC voltage/current to be supplied to a DC link or a battery, such as a battery of an electric vehicle. It also may be possible that the power module is an inverter which generates an AC voltage/current from a DC voltage/current to be supplied to an electrical motor, such as the motor of an electric vehicle. The inverter may also be used to change the frequency of an AC voltage/current to another frequency of an AC voltage/current. The power module may be used in automotive applications, such as electric cars, motorbikes, buses, off-road construction vehicles, trucks, charging stations or power plants or traction applications.

According to a further embodiment, the connection areas of the first and the second connection element are exposed and freely accessible in an unconnected configuration of the power module. Particularly, the connection areas are not covered by the housing, i.e. are free of the housing.

Next, the method for producing an arrangement for a power module is specified. For example, the method is used for producing an arrangement according to any one of the embodiments described herein. Therefore, all features disclosed in connection with the arrangement are also disclosed for the method and vice versa.

According to an embodiment of the method, the method for producing an arrangement for a power module comprises a step of electrically and mechanically connecting a first connection element to a contact area in a first bond region by means of a bonding process. In a further step, a second connection element is electrically and mechanically connected to the first connection element in a second bond region by means of laser welding and not ultrasonic welding.

For example, firstly, the first connection element is bonded to the contact area and afterwards the second connection element is laser welded onto the first connection element. The laser welding may be done with an IR laser or a green laser.

According to the method of the invention, the first bond region and the second bond region are formed such that they overlap at least partly with each other in plan view of the contact area. Particularly, one or more second joints between the first and the second connection element may overlap at least partly with one or more first joints between the first connection element and the contact area.

According to a further embodiment of the method, the laser parameters of the laser beam used for the laser welding are given to beneficially affect the laser welding. The laser beam or a corresponding laser source used for laser welding can be configured to provide a laser power of 300 W to 3000 W. Alternatively or additionally, the laser beam or the laser source for laser welding can be configured to provide a traveling speed of the laser beam of 1 mm/s to 200 mm/s guided along a top side of the second connection element that faces the impinging laser beam. The laser beam itself or the workpiece may be moved. Thus, the welding does not have to be done only at one limited point and the laser spot of the laser beam providing the welding process can be moved with an aforementioned velocity to provide a welding joint over a defined area.

The laser beam can also be configured to oscillate with a predetermined frequency. Thus, the laser spot position can oscillate or wobble with a frequency of up to 2 kHz and/or an amplitude of up to 500 µm to beneficially affect the welding process e.g. by prevention of local overheating.

Hereinafter, the arrangement for a power module, the power module and the method for producing an arrangement for a power module will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figures 1 to 5 show different exemplary embodiments of the arrangement for a power module in a cross-sectional view,
Figure 6 shows the exemplary embodiment of figure 5 in plan view,
Figures 7 and 8 show exemplary embodiments of the power module in cross-sectional view,
Figures 9 and 10 show detailed views of exemplary embodiments of the first and second bond regions in plan view,
Figure 11 shows a flowchart of an exemplary embodiment of the method for producing an arrangement for a power module and
Figures 12 and 13 show further exemplary embodiments of the arrangement for a power module.

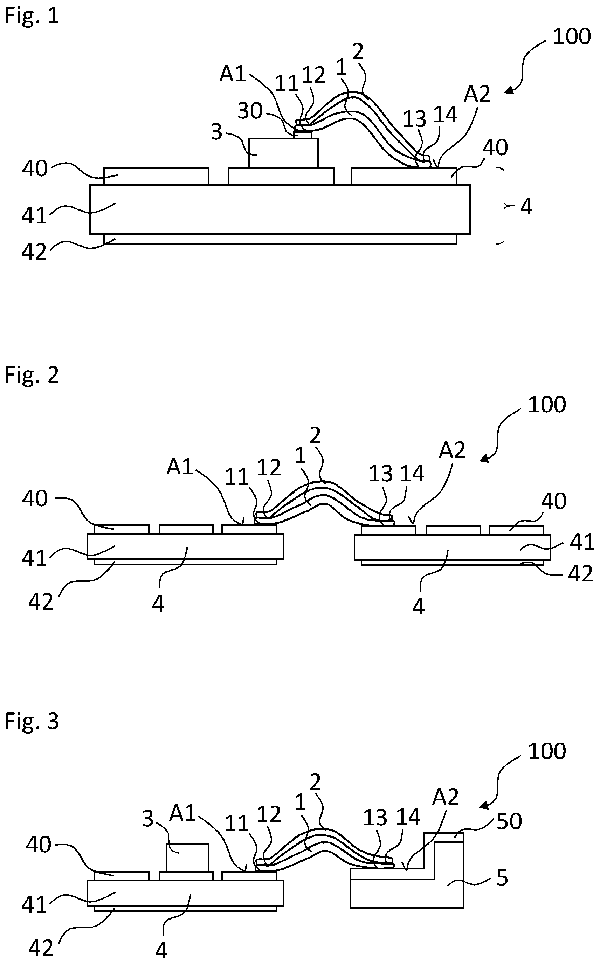

Figure 1 shows a first exemplary embodiment of the arrangement 100 for a power module. The arrangement 100 comprises a substrate 4 with a top metallization 40, a bottom metallization 42 and an electrically insulating layer 41 sandwiched between the top 40 and the bottom 42 metallization. For example, the metallizations 40, 42 comprise Cu or Al or a corresponding alloy thereof. A surface of the top metallization 40 facing away from the insulating layer 41 may be formed of Ni, Au or Ag coating. The insulating layer 41 is, e.g., formed of an electrically insulating polymer or a ceramic.

The top metallization 40 comprises three different areas. A power semiconductor device 3, e.g. an IGBT or MOSFET, is mounted on the middle area and connected thereto. On a top side of the power semiconductor module 3, facing away from the substrate 4, a contact area A1 of the power semiconductor device 3 is formed. The contact area A1 is, formed by a main electrode 30, like an emitter electrode or source electrode or collector electrode or drain electrode of the power semiconductor device 3.

A first connection element 1 in the form of a ribbon is firmly bonded to the contact area A1. The region in which the joint(s) (first joint(s)) between the first connection element 1 and a contact area A1 are formed is called first bond region 11. In accordance with the claimed invention, the first connection element 1 is welded to the contact area A1 by means of ultrasonic welding. Other bonding processes producing firm bonds, like laser welding, soldering, sintering, are, however, in embodiment not forming part of the claimed invention, also possible.

A second connection element 2, also realized by a ribbon, is welded to the first connection element 1 in a second bond region 12 by means of laser welding. The second bond region 12 is, again, defined by the joint(s) (second joint(s)) formed between the first connection element 1 and the second connection element **2.**

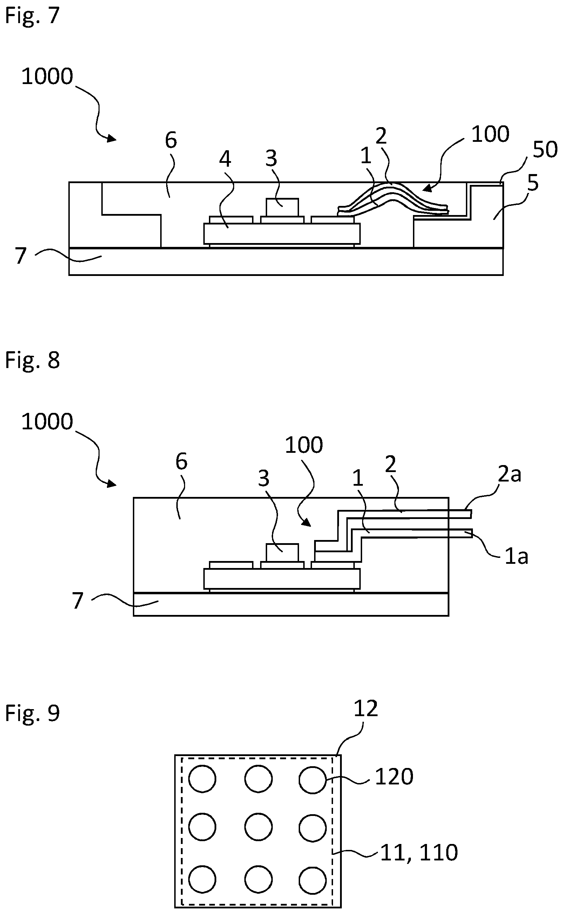

In plan view of the contact area A1, the first bond region 11 and the second bond region 12 overlap at least partly with each other. This plan view is, **e.g.,** illustrated in figure **9****.** As can be seen there, the second bond region 12 is defined by a plurality of laser welded joints (second joints) 120 which are laterally spaced from each other. The first bond region 11 is realized by a single, contiguous joint (first joint) 110 which overlaps with each of the laser welded second joints 120.

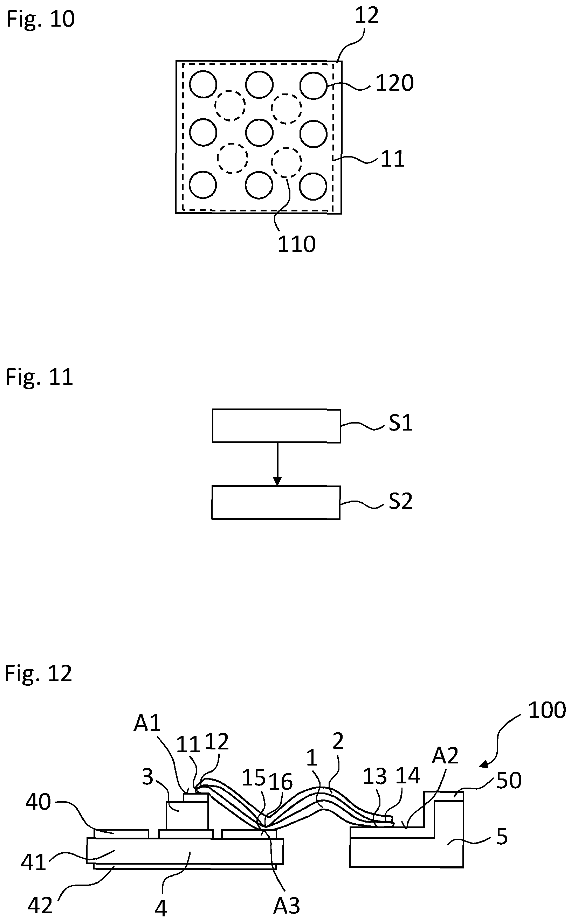

Alternatively, if, in an embodiment not in accordance with the invention, also the first connection element 1 were welded to the contact area A1 by means of laser welding, there could be several, laterally spaced first welding joints 110. These first welding joints 110 could either at least partly overlap with the second welding joints 120 in plan view or could be arranged in a staggered configuration with the second welding joints 120 in which they do not overlap with each other in plan view. This second case is illustrated in figure 10.

Coming back to figure 1, the first connection element 1 is further firmly bonded to a further contact area A2 in a third bond region 13. The further contact area A2 is formed by the top metallization 40 of the substrate 4. Also here, the first connection element 1 may be firmly bonded to the further contact area A2 by means of ultrasonic welding or laser welding or soldering etc. The second connection element 2 is laser welded onto the first connection element 1 in a fourth bond region 14 at least partly overlapping with the third bond region 13 in plan view of the further contact area A2. The same as described for the first and second bond regions and in connection with figures 9 and 10 may also apply for the third 13 and fourth 14 bond regions.

The two connection elements 1, 2 of figure 1 are stacked above each other and, thus, realize two parallel electrical connections between the contact area A1 and the further contact area A2. This type of stacked connection elements saves space and additionally allows larger currents to be transmitted than could be realized with one single connection element in the form of a ribbon because less parallel connections are needed.

Figure 2 shows a second exemplary embodiment of the arrangement 100. In this case, two substrates 4, each formed as that of figure 1, are electrically connected by means of two stacked connection elements 1, 2. Also here, the first connection element 1 is a ribbon which is firmly bonded to the contact area A1 of the left substrate 4, e.g. by means of ultrasonic welding (according to the invention) or laser welding (in an embodiment not in accordance with the invention), and firmly bonded to the further contact area A2 of the right substrate 4, e.g. by means of ultrasonic welding or laser welding. The two ends of the second connection element 2 are laser welded onto the two ends of the first connection element 1.

Figure 3 shows a third exemplary embodiment. Here, the two connection elements 1, 2 are electrically connected to a top metallization 40 of a substrate 4 and a terminal 50 of the arrangement 100, namely to the top side of a terminal foot thereof. The terminal 50 is a metal element which may be arranged on or at least partly integrated into a housing element 5 of the arrangement 100 and is configured for an external electrical connection of the arrangement 100. Concerning the firm bonds in the bond regions 11, 12, 13, 14, the same as described in connection with the last two embodiments applies here.

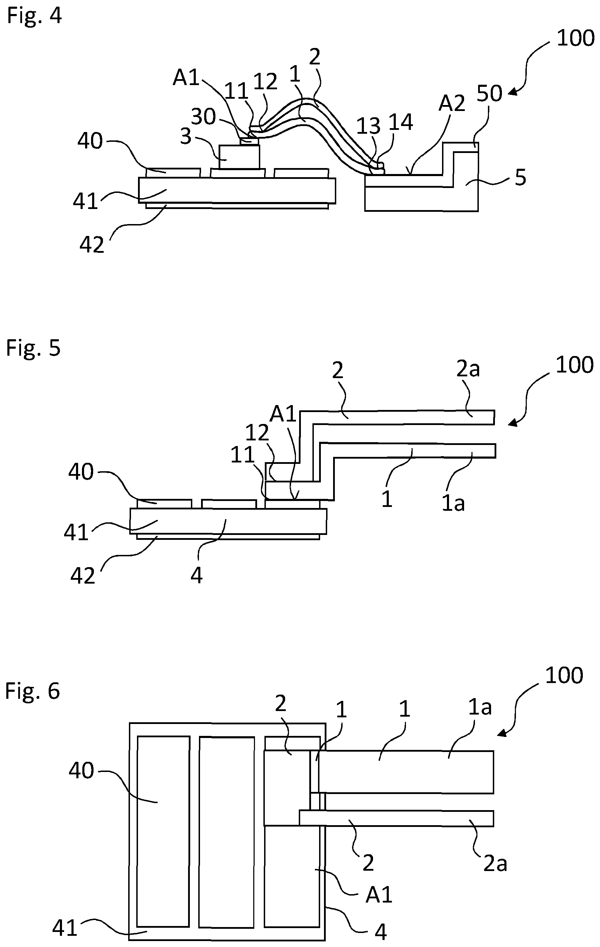

In figure 4, a fourth exemplary embodiment is shown, in which a power semiconductor device 3 mounted on a substrate 4 is electrically connected to a terminal 50 by means of a first 1 and a second 2 connection element. Also here, the firm bonds in the bond regions 11, 12, 13, 14 are as described for the previous exemplary embodiments.

Figure 5 shows a fifth exemplary embodiment. Here, the connection elements 1, 2 are realized by terminals. The terminals 1, 2 are rigid elements, e.g. leadframes or busbars, which each comprise a connection portion 1a, 2a for an external electrical connection.

The terminals 1, 2 each comprise a terminal foot which is used for the firm bonds. Concerning the firm bond between the first terminal 1 in the first bond region 11 and the welded bond of the second terminal 2 in the second bond region 12, the same applies as described in the previous exemplary embodiments.

Figure 6 shows the exemplary embodiment of figure 5 in plan view of the contact area A1. As can be seen here, the connection portions 1a, 2a of the first terminal 1 and the second terminal 2 are laterally spaced from each other. Furthermore, the first terminal 1 is broader than the second terminal 2. The first terminal 1 may be a main terminal of the arrangement 100 and the second terminal 2 may be an auxiliary terminal of the arrangement 100, e.g. for control or measurement purposes. The first bond region 11 is, for example, larger than the second bond region 12. The bond regions 11, 12 partly overlap with each other in plan view of the contact area A1.

Also in the case of two terminals welded on top of each other, as described in connection with figures 5 and 6, space can be saved.

Figure 7 shows a first exemplary embodiment of the power module 1000 in a cross-sectional view. The power module 1000 comprises a baseplate 7, e.g. made of metal or ceramic or a composite material like aluminum silicon carbide or magnesium silicon carbide, on top of which the arrangement 100 according to figure 3 is mounted. The baseplate 7 is configured for cooling or use as heat sink.

The power module 1000 comprises a housing 5, 6 which is partially formed by the housing element 5 in form of a frame and/or cover on top of which the terminal 50 is formed or in which the terminal 50 is partly embedded and partially by an encapsulation 6, which encapsulates the substrate 4 and the power semiconductor device 3 and a portion of the terminal 50. The frame 5 forms a cavity into which the encapsulation is filled. The encapsulation 6 is, e.g., a gel or a mold.

Also the ribbons 1, 2 are encapsulated in the encapsulation 6.

A second exemplary embodiment of the power module 1000 is shown in figure 8. Here, the arrangement 100 of figures 5 and 6 is mounted on a baseplate 7, which is, e.g., formed as that of figure 7. The power module 1000 further comprises a housing 6 in the form of an electrically insulating encapsulation. The encapsulation 6 is, e.g., formed by transfer molding. The connection portions 1a, 2a of the terminals 1, 2 project out of the encapsulation 6 and are, therefore, freely accessible for an external electrical connection of the power module 1000 to an external component. The power modules of figures 7 and 8 may each comprise arrangements according to figures 1 to 6. Particularly, a power module may comprise several stacks of at least a first and a second connection element as described herein. These several stacks may electrically connect different elements of the arrangement. Alternatively, two or more stacks may electrically connect the same elements, wherein the use of two or more stacks further increase the current capability.

Figure 11 shows a flowchart of an exemplary embodiment of the method for producing an arrangement. In a step S1, a first connection element is electrically and mechanically connected to a contact area in a first bond region by means of a bonding process, e.g. ultrasonic welding (in embodiments of the invention) or laser welding or soldering (in embodiments not falling within the scope of the invention).

In a step S2, a second connection element is electrically and mechanically connected to the first connection element in a second bond region by means of laser welding.

Figure 12 shows a further exemplary embodiment of an arrangement, where two connection elements 1, 2 connect a power semiconductor device 3 with a top metallization 40 of a substrate 4 and further with a terminal 50. For this purpose a first end of the first connection element 1, being for example a ribbon, is firmly bonded to a contact area A1 in a first bond region 11, wherein the first contact area A1 is formed by the power semiconductor device 2. A first end of the second connection element 2, being for example also a ribbon, is laser welded onto the first connection element 1 in a second bond region 12. The second ends of the first 1 and second 2 connection element are firmly bonded to a further contact area A2 formed by the terminal 50 and laser welded onto each other, respectively, in a third 13 and fourth 14 bond region. A stitched electrical connection to the top metallization 40 is formed between the first and second ends of the connection elements. Therefore, the first connection element is firmly bonded to a third contact area A3 formed by the top metallization 40 in a fifth bond region 15 and the second connection element 2 is laser welded onto the first connection element 1 in a sixth bond region 16 overlapping with the bond region 15 in plan view of the third contact area A3.

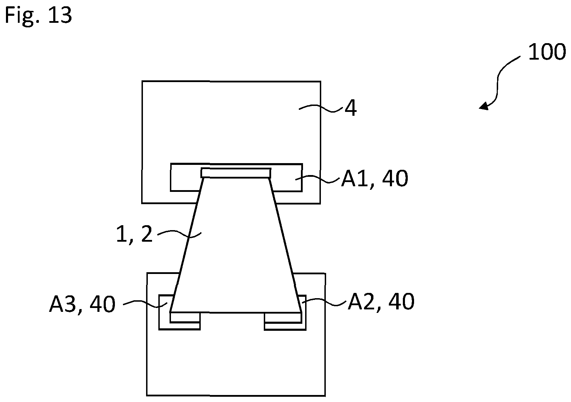

Figure 13 shows an exemplary embodiment of the arrangement, where two substrates are electrically interconnected by two clips 1, 2. Figure 13 shows a plan view so that only the second clip 2 covering the first clip 1 is visible. The clips 1, 2 are pre-bend metal sheets. A first foot of the first clip 1 is firmly bonded to a contact area A1 formed by a top metallization 40 of a first substrate 4. A first foot of the second clip 2 is laser welded onto the first foot of the first clip 1. Moreover, a second foot of the first clip 2 and a third foot of the first clip 2 are firmly bonded to two different contact areas A2, A3 formed by different top metallizations 40 of a second substrate 4. A second foot of the second clip 2 is laser welded onto the second foot of the first clip 2 and a third foot of the second clip 2 is laser welded onto the third foot of the first clip 1.

The embodiments shown in the Figures 1 to 11 as stated represent exemplary embodiments. Therefore, they do not constitute a complete list of all embodiments according to the arrangement, the power module and the method. Actual arrangements, power modules and methods may vary from the embodiments shown in terms of devices and elements for example.

The scope of the invention is defined by the appended claims.

### Reference signs

- 1: first connection element
- 2: second connection element
- 3: power semiconductor device
- 4: substrate
- 5: housing element
- 6: encapsulation
- 7: baseplate
- 11: first bond region
- 12: second bond region
- 13: third bond region
- 14: fourth bond region
- 15: fifth bond region
- 16: sixth bond region
- 30: electrode
- 40: top metallization
- 41: insulating layer
- 42: bottom metallization
- 50: terminal
- 100: arrangement
- 1000: power module
- S1: method step
- S2: method step
- A1: contact area
- A2: further contact area
- A3: third contact area

## Claims

1. Arrangement (100) for a power module comprising
- an electrically conductive contact area (30, 40, 50),
- a first (1) and a second (2) connection element for electrically connecting the contact area (A1), wherein
- the first connection element (1) is firmly bonded to the contact area (A1) in a first bond region (11),
- the second connection element (2) is welded to the first connection element (1) in a second bond region (12) by means of laser welding and not ultrasonic welding,
- the first connection element (1) is welded to the contact area (A1) by means of ultrasonic welding, whereby the first (1) and/or the second (2) connection element are clips or ribbons, wherein
- the first (11) and the second (12) bond region overlap at least partly with each other in plan view of the contact area (A1).

2. Arrangement (100) according to any one of the preceding claims, wherein
- the first (1) and the second (2) connection element are stacked above each other.

3. Arrangement (100) according to any one of the preceding claims, wherein
- the first (1) and second (2) connection element electrically connect the contact area (A1) to a further contact area (A2) of the arrangement (100),
- the first connection element (1) is firmly bonded to the further contact area (A2) in a third bond region (13),
- the second connection element (2) is welded to the first connection element (1) in a fourth bond region (14) by means of laser welding,
- the third (13) and the fourth (14) bond region overlap with each other at least partly in plan view of the further contact area (A2).

4. Arrangement (100) according to any one of the preceding claims, wherein
- the contact area (A1) is formed by a
- a top metallization (40) of a substrate (4) of the arrangement (100) or
- a power semiconductor device (3) of the arrangement (100) or
- a terminal (50) for an external electrical connection of the arrangement (100).

5. Arrangement (100) according to claim 3 or claim 4 in its dependency of claim 3, wherein
- the further contact area (A2) is formed by
- a top metallization (40) of a substrate (4) of the arrangement (100) or
- a power semiconductor device (3) of the arrangement (100) or
- a terminal (50) for an external electrical connection of the arrangement (100).

6. Arrangement (100) according to any one of the preceding claims, wherein
- the second connection element (2) is connected to the first connection element (1) via a plurality of laser welded welding joints (120) distributed over the second bond region (12) and spaced pairwise from each other.

7. Power module (1000) comprising
- the arrangement (100) according to any one of the preceding claims.

8. Method for producing an arrangement (100) for a power module comprising:
- electrically and mechanically connecting a first connection element (1) to a contact area (A1) in a first bond region (11) by means of a bonding process,
- electrically and mechanically connecting a second connection element (2) to the first connection element (1) in a second bond region (12) by means of laser welding and not ultrasonic welding, wherein
- the first connection element (1) is welded to the contact area (A1) by means of ultrasonic welding, whereby the first (1) and/or the second (2) connection element are clips or ribbons, wherein
- the first (11) and the second (12) bond region overlap at least partly with each other in plan view of the contact area (A1).

## Patentansprüche

1. Anordnung (100) für ein Leistungsmodul, umfassend:
- eine elektrisch leitfähige Kontaktfläche (30, 40, 50),
- ein erstes (1) und ein zweites (2) Verbindungselement zum elektrischen Verbinden der Kontaktfläche (A1), wobei
- das erste Verbindungselement (1) in einem ersten Bondbereich (11) fest mit der Kontaktfläche (A1) gebondet ist,
- das zweite Verbindungselement (2) in einem zweiten Bondbereich (12) mittels Laserschweißen und nicht mittels Ultraschallschweißen mit dem ersten Verbindungselement (1) verschweißt ist,
- das erste Verbindungselement (1) mittels Ultraschallschweißen mit der Kontaktfläche (A1) verschweißt ist, wobei das erste (1) und/oder das zweite (2) Verbindungselement Clips oder Bänder sind, wobei
- der erste (11) und der zweite (12) Bondbereich einander in Draufsicht auf die Kontaktfläche (A1) zumindest teilweise überlappen.

2. Anordnung (100) nach einem der vorhergehenden Ansprüche, wobei
- das erste (1) und das zweite (2) Verbindungselement übereinander angeordnet sind.

3. Anordnung (100) nach einem der vorhergehenden Ansprüche, wobei
- das erste (1) und das zweite (2) Verbindungselement die Kontaktfläche (A1) elektrisch mit einer weiteren Kontaktfläche (A2) der Anordnung (100) verbinden,
- das erste Verbindungselement (1) in einem dritten Bondbereich (13) fest mit der weiteren Kontaktfläche (A2) gebondet ist,
- das zweite Verbindungselement (2) in einem vierten Bondbereich (14) mittels Laserschweißen mit dem ersten Verbindungselement (1) verschweißt ist,
- der dritte (13) und der vierte (14) Bondbereich einander in Draufsicht auf die weitere Kontaktfläche (A2) zumindest teilweise überlappen.

4. Anordnung (100) nach einem der vorhergehenden Ansprüche, wobei
- die Kontaktfläche (A1) gebildet ist durch
- eine obere Metallisierung (40) eines Substrats (4) der Anordnung (100) oder
- eine Leistungshalbleitervorrichtung (3) der Anordnung (100) oder
- einen Anschluss (50) für einen externen elektrischen Anschluss der Anordnung (100).

5. Anordnung (100) nach Anspruch 3 oder Anspruch 4 in seiner Rückbeziehung auf Anspruch 3, wobei
- die weitere Kontaktfläche (A2) gebildet ist durch
- eine obere Metallisierung (40) eines Substrats (4) der Anordnung (100) oder
- eine Leistungshalbleitervorrichtung (3) der Anordnung (100) oder
- einen Anschluss (50) für einen externen elektrischen Anschluss der Anordnung (100).

6. Anordnung (100) nach einem der vorhergehenden Ansprüche, wobei
- das zweite Verbindungselement (2) über eine Vielzahl von lasergeschweißten Schweißverbindungen (120), die über den zweiten Bondbereich (12) verteilt sind und paarweise voneinander beabstandet sind, mit dem ersten Verbindungselement (1) verbunden ist.

7. Leistungsmodul (1000), umfassend:
- die Anordnung (100) nach einem der vorhergehenden Ansprüche.

8. Verfahren zum Herstellen einer Anordnung (100) für ein Leistungsmodul, umfassend:
- elektrisches und mechanisches Verbinden eines ersten Verbindungselements (1) mit einer Kontaktfläche (A1) in einem ersten Bondbereich (11) mittels eines Bondverfahrens,
- elektrisches und mechanisches Verbinden eines zweiten Verbindungselements (2) mit dem ersten Verbindungselement (1) in einem zweiten Bondbereich (12) mittels Laserschweißen und nicht mittels Ultraschallschweißen, wobei
- das erste Verbindungselement (1) mittels Ultraschallschweißen mit der Kontaktfläche (A1) verschweißt ist, wobei das erste (1) und/oder das zweite (2) Verbindungselement Clips oder Bänder sind, wobei
- der erste (11) und der zweite (12) Bondbereich einander in Draufsicht auf die Kontaktfläche (A1) zumindest teilweise überlappen.

## Revendications

1. Agencement (100) pour un module de puissance comprenant :
- une zone de contact électroconductrice (30, 40, 50),
- un premier (1) et un deuxième (2) élément de connexion pour se connecter électriquement à la zone de contact (A1), dans lequel
- le premier élément de connexion (1) est fermement lié à la zone de contact (A1) dans une première région de liaison (11),
- le deuxième élément de connexion (2) est soudé au premier élément de connexion (1) dans une deuxième région de liaison (12) au moyen d'une soudure au laser et non d'une soudure par ultrasons,
- le premier élément de connexion (1) est soudé à la zone de contact (A1) au moyen d'une soudure par ultrasons, moyennant quoi le premier (1) et/ou le deuxième (2) élément de connexion sont des clips ou des rubans, dans lequel
- la première (11) et la deuxième (12) région de liaison se chevauchent au moins en partie l'une avec l'autre en vue en plan de la zone de contact (A1).

2. Agencement (100) selon l'une quelconque des revendications précédentes, dans lequel
- le premier (1) et le deuxième (2) élément de connexion sont empilés l'un au-dessus de l'autre.

3. Agencement (100) selon l'une quelconque des revendications précédentes, dans lequel
- le premier (1) et le deuxième (2) élément de connexion connectent électriquement la zone de contact (A1) à une zone de contact (A2) supplémentaire de l'agencement (100),
- le premier élément de liaison (1) est fermement lié à la zone de contact (A2) supplémentaire dans une troisième région de liaison (13),
- le deuxième élément de connexion (2) est soudé au premier élément de connexion (1) dans une quatrième région de liaison (14) au moyen d'une soudure au laser,
- la troisième (13) et la quatrième (14) région de liaison se chevauchent au moins en partie l'une avec l'autre en vue en plan de la zone de contact (A2) supplémentaire.

4. Agencement (100) selon l'une quelconque des revendications précédentes, dans lequel
- la zone de contact (A1) est formée par
- une métallisation supérieure (40) d'un substrat (4) de l'agencement (100) ou
- un dispositif semiconducteur de puissance (3) de l'agencement (100) ou
- une borne (50) pour une connexion électrique externe de l'agencement (100).

5. Agencement (100) selon la revendication 3 ou la revendication 4 dans sa dépendance à la revendication 3, dans lequel
- la zone de contact (A2) est formée par
- une métallisation supérieure (40) d'un substrat (4) de l'agencement (100) ou
- un dispositif semiconducteur de puissance (3) de l'agencement (100) ou
- une borne (50) pour une connexion électrique externe de l'agencement (100).

6. Agencement (100) selon l'une quelconque des revendications précédentes, dans lequel
- le deuxième élément de connexion (2) est lié au premier élément de connexion (1) par l'intermédiaire d'une pluralité de joints de soudure soudés au laser (120) répartis sur la deuxième zone de liaison (12) et espacés deux à deux les uns des autres.

7. Module de puissance (1000) comprenant
- l'agencement (100) selon l'une quelconque des revendications précédentes.

8. Procédé de fabrication d'un agencement (100) pour un module de puissance comprenant :
- la connexion électrique et mécanique d'un premier élément de liaison (1) à une zone de contact (A1) dans une première région de liaison (11) au moyen d'un processus de liaison,
- la connexion électrique et mécanique d'un deuxième élément de connexion (2) au premier élément de connexion (1) dans une deuxième région de liaison (12) au moyen d'une soudure au laser et non par ultrasons, dans lequel
- le premier élément de connexion (1) est soudé à la zone de contact (A1) au moyen d'une soudure par ultrasons, moyennant quoi le premier (1) et/ou le deuxième (2) élément de connexion sont des clips ou des rubans, dans lequel
- la première (11) et la deuxième (12) région de liaison se chevauchent au moins en partie l'une avec l'autre en vue en plan de la zone de contact (A1).
